# EUROPEAN PATENT APPLICATION

(11) **EP 4 826 553 A1**
(43) Date of publication of application: **21.10.2026**
(21) Application number: 25221038.0
(22) Date of filing: 05.12.2025
(51) Int. Cl.: G06F 13/16, G11C 5/04, G11C 8/12

(54) **METHODS AND APPARATUS FOR DYNAMIC CHIP SELECT MODES**

(30) Priority: 15.04.2025 US 202563789298 P; 15.08.2025 US 202519301700
(71) Applicant: INTEL Corporation, Santa Clara, CA 95054 (US)
(72) Inventor: HINCK, Todd Andrew, Arlington, 02476 (US); MOZAK, Christopher P., Portland, 97229 (US); MCCALL, James Alexander, Portland, 97229 (US); THOMAS, Alex Peter, Folsom, 95630 (US); SETHURAMAN, Saravanan, Oregon, 97229 (US)
(74) Representative: Viering, Jentschura & Partner mbB Patent- und Rechtsanwälte

(57) **Abstract**

Systems, apparatus, articles of manufacture, and methods are disclosed for dynamic chip select modes. An example system includes a memory module including a first rank of dynamic random access devices (DRAMs), a second rank of DRAMs, and a third rank of DRAMs, a first signal line coupled to the memory module, a second signal line coupled to the memory module, and a host memory controller coupled to the first and second signal lines, the host memory controller to generate a multi-bit signal that selects the third rank of DRAM devices, and transmit bits of the multi-bit signal over the second signal line over multiple clock cycles.

## Description

### RELATED APPLICATION

This patent claims the benefit of U.S. Provisional Patent Application No. 63/789,298, which was filed on April 15, 2025. U.S. Provisional Patent Application No. 63/789,298 is hereby incorporated herein by reference in its entirety. Priority to U.S. Provisional Patent Application No. 63/789,298 is hereby claimed.

### BACKGROUND

The standardization of many memory subsystem processes allows for interoperability among different device manufacturers. The standardization allows building devices with different architectural designs and different processing technologies which will function according to specified guidelines. Memory devices receive commands from memory controllers over command buses. In the case of buffered memory modules, a buffer device (such as a registering clock driver (RCD)) receives the command signals from the host memory controller over "frontside" signal lines and forwards or sends command signals to the memory devices over "backside" signal lines. A chip select (CS) signal is used to identify a device that should execute a command on the command bus and can operate as a trigger for the sending and receiving of data and commands. CA (command and address) signals are used to communicate command and address information.

### BRIEF DESCRIPTION OF THE DRAWINGS

FIG. 1 is a block diagram of an example memory subsystem in which an example memory controller operates to configure a chip select bit based on a number of ranks included in the memory module.
FIG. 2 is a flowchart representative of example machine readable instructions and/or example operations that may be executed, instantiated, and/or performed by example programmable circuitry to implement the memory controller of FIG. 1.
FIG. 3 is a block diagram of an example first implementation of the memory subsystem of FIG. 1.
FIG. 4 is a truth table that corresponds to the first implementation of the memory subsystem illustrated in FIG. 3.
FIG. 5 is a block diagram of an example second implementation of the memory subsystem of FIG. 1.
FIG. 6 is a truth table that corresponds to the second implementation of the memory subsystem illustrated in FIG. 5.
FIG. 7 is a block diagram of an example third implementation of the memory subsystem of FIG. 1.
FIG. 8 is a truth table that corresponds to the third implementation of the memory subsystem illustrated in FIG. 7.
FIG. 9 is a block diagram of an example fourth implementation of the memory subsystem of FIG. 1.
FIG. 10 is a truth table that corresponds to the fourth implementation of the memory subsystem illustrated in FIG. 9.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Memory devices each include memory resources. Memory resources represent individual arrays of memory locations or storage locations for data. Typically, memory resources are managed as rows of data, accessed via wordline (rows) and bitline (individual bits within a row) control. Memory resources can be organized as separate channels, ranks, and banks of memory. Channels may refer to independent control paths to storage locations within memory devices. A rank refers to memory devices coupled with the same chip select. Ranks may refer to common locations across multiple memory devices (e.g., same row addresses within different devices). Banks may refer to arrays of memory locations within a memory device. In some examples, banks of memory are divided into sub-banks with at least a portion of shared circuitry (e.g., drivers, signal lines, control logic) for the sub-banks, allowing separate addressing and access. In some examples, channels, ranks, banks, sub-banks, bank groups, or other organizations of the memory locations, and combinations of the organizations, can overlap in their application to physical resources. For example, the same physical memory locations can be accessed over a specific channel as a specific bank, which can also belong to a rank. Thus, the organization of memory resources will be understood in an inclusive, rather than exclusive, manner.

A host includes input/output (I/O) interface circuitry to couple a memory controller to memory resources of a memory devices. I/O interface circuitry can include pins, pads, connectors, signal lines, traces, wires, or other hardware to connect the devices, or a combination of these. In some examples, the more ranks of memory devices, the more chip select (CS) pins included on the I/O interface circuitry. For example, conventionally there is a one-to-one ratio of ranks to CS pins (e.g., 2 ranks, 2 CS pins; 3 ranks, 3 CS pins, etc.). To select a rank or to not select a rank, the memory controller generates information on the corresponding CS pin, such as high (H) or low (L). For example, in a three rank memory module, the memory controller selects rank 3 by sending a logic high (1) through the CS pin 3, and a logic low (0) through CS pins 1 and 2.

The demand for higher-performance computing is high. Applications in artificial intelligence (AI), big data analytics, machine learning, and databases require high-speed memory systems to handle the ever-increasing demand and complexities of data. Advancements in cloud computing and machine virtualization are exceeding limits of the current capabilities of memory systems. Such advancements in computing need more bandwidth than what current memory systems can provide.

Additional ranks of memory devices are added to address the current bandwidth challenge. However, with added ranks of memory devices, there is an increased pin count of the memory system. Adding more CS pins to the memory system increases costs. Therefore, there is a need for memory systems with a smaller pin count and an improved bandwidth per pin efficiency. As used herein, bandwidth per pin efficiency refers to increases the amount of data that can be transferred through each pin, increasing the overall memory bandwidth.

Examples disclosed herein improve bandwidth per pin efficiency memory systems while reducing the overall chip select (CS) pin count. Examples disclosed herein reduce the CS pin count by encoding bits of the chip select signal on one of the CS pins. For example, the memory controller can configure the bits of the CS signal to select up to 8 ranks, rather than just 1 rank. By encoding the CS bit, fewer CS pins are needed for the increased ranks of memory devices. For example, in a three rank (3R) memory module, only two CS pins are needed to select up to three ranks of memory, rather than three CS pins. Examples disclosed herein change the logic of how information is sent through the CS pin when more than 2 ranks of memory are included in the memory module. The logic used to encode the CS bit on the CS pin is similar to the logic used for the command bits sent on the CA pin. Therefore, chip select will be configured similar to the CA pin, such that CS information (e.g., 0s and 1s) is sent on all six unit intervals (UI) from the memory controller to the memory module.

Examples disclosed herein improve bandwidth-per-pin efficiency by reducing the number of pins and increasing the number of unit intervals (UI) per command. For example, there is more information being sent on the CS pin, and there are less pins. There is more bandwidth in the sense that one pin (e.g., the CS pin) can send more data.

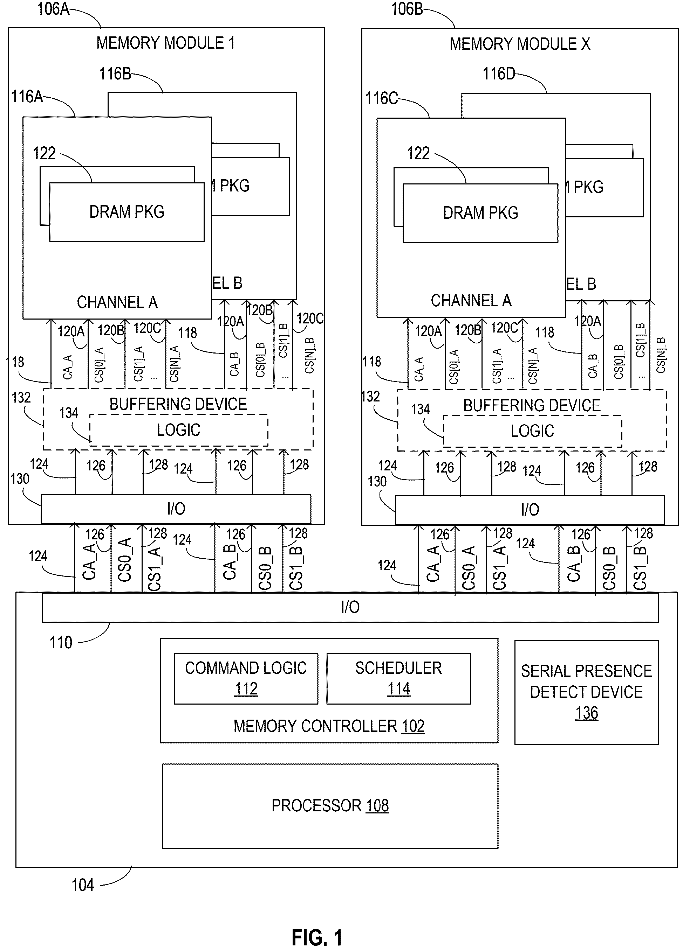

FIG. 1 is a block diagram of an example memory subsystem 100 in which an example memory controller 102 operates to configure a chip select bit based on a number of ranks included in the memory module. Memory subsystem 100 includes an example host computing platform 104 and example memory modules 106A, 106B. Memory subsystem 100 can be implemented as an SOC (system on a chip) or be implemented with standalone components.

The computing platform 104 represents a processing unit of a computing device that may execute an operating system (OS) and applications, which can collectively be referred to as the host or the user of the memory. The OS and applications execute operations that result in memory accesses. The computing platform 104 includes an example processor 108, the memory controller 102, and example input/output (I/O) interface 110. The processor 108 can include one or more separate processors. Each separate processor can include a single processing unit, a multicore processing unit, or a combination. The processor 108 can be a primary processor such as a CPU (central processing unit), a peripheral processor such as a GPU (graphics processing unit), or a combination. The processor 108 initiates memory accesses. In some examples, memory accesses may also be initiated by devices such as a network controller or hard disk controller. Such devices can be integrated with the processor in some systems or attached to the processer via a bus (e.g., PCI express), or a combination.

The memory controller 102 represents one or more memory controller circuits or devices for the computing platform 104. The memory controller 102 accesses one or more memory channels 116A, 116B, 116C, 116D (e.g., 116A-D). Memory channels 116A-D may be referred to as memory devices, such that memory devices are organized and managed as different channels, where each channel 116 couples to buses and signal lines 118, 120A, 120B, 120C (e.g., 120A-C) that couple to multiple memory devices in parallel. Each memory channel 116A-D is independently operable. Thus, each memory channel 116A-D is independently accessed and controlled, and the timing, data transfer, command and address exchanges, and other operations are separate for each memory channel 116A-D. Coupling can refer to an electrical coupling, communicative coupling, physical coupling, or a combination of these. Physical coupling can include direct contact. Electrical coupling includes an interface or interconnection that allows electrical flow between components, or allows signaling between components, or both. Communicative coupling includes connections, including wired or wireless, that enable components to exchange data.

Reference to memory devices can apply to different memory types. Memory devices often refers to volatile memory technologies. Volatile memory is memory whose state (and therefore the data stored in it) is indeterminate if power is interrupted to the device. Dynamic volatile memory requires refreshing the data stored in the device to maintain state. One example of dynamic volatile memory incudes DRAM (Dynamic Random Access Memory), or some variant such as Synchronous DRAM (SDRAM). The memory subsystem 100 may be compatible with a number of memory technologies, such as DDR3 (Double Data Rate version 3, original release by JEDEC (Joint Electronic Device Engineering Council) on Jun. 27, 2007). DDR4 (DDR version 4, originally published in September 2012 by JEDEC), DDR5 (DDR version 5, originally published in July 2020), LPDDR3 (Low Power DDR version 3, JESD209-3B, August 2013 by JEDEC), LPDDR4 (LPDDR version 4, JESD209-4, originally published by JEDEC in August 2014), LPDDR5 (LPDDR version 5, JESD209-5A, originally published by JEDEC in January 2020), WIO2 (Wide Input/Output version 2, JESD229-2 originally published by JEDEC in August 2014), HBM (High Bandwidth Memory, JESD235, originally published by JEDEC in October 2013), HBM2 (HBM version 2, JESD235C, originally published by JEDEC in January 2020), or HBM3 (HBM version 3 currently in discussion by JEDEC), or others or combinations of memory technologies, and technologies based on derivatives or extensions of such specifications. The JEDEC standards are available at www.jedec.org.

Additionally and/or alternatively, in one embodiment, reference to memory devices can refer to a nonvolatile memory device whose state is determinate even if power is interrupted to the device. In one embodiment, the nonvolatile memory device is a block addressable memory device, such as NAND or NOR technologies. Thus, a memory device can also include a future generation nonvolatile devices, such as a three dimensional crosspoint memory device, other byte addressable nonvolatile memory devices, or memory devices that use chalcogenide phase change material. In one embodiment, the memory device can be or include multi-threshold level NAND flash memory, NOR flash memory, single or multi-level phase change memory (PCM) or phase change memory with a switch (PCMS), a resistive memory, nanowire memory, ferroelectric transistor random access memory (FeTRAM), magnetoresistive random access memory (MRAM) memory that incorporates memristor technology, or spin transfer torque (STT)-MRAM, or a combination of any of the above, or other memory.

In FIG. 1, the memory channels 116A-D include one more memory packages 122 (DRAM packages 122). Descriptions referring to a "DRAM", a "DRAM device", or a "DRAM package" can refer to a volatile random access memory device. The memory packages 122 store data. The memory device or DRAM can refer to the die itself, to a packaged memory product that includes one or more dies, or both. In one embodiment, a system with volatile memory that needs to be refreshed can also include nonvolatile memory. However, as mentioned above, the memory channels 116A-D may include any other types of memory devices.

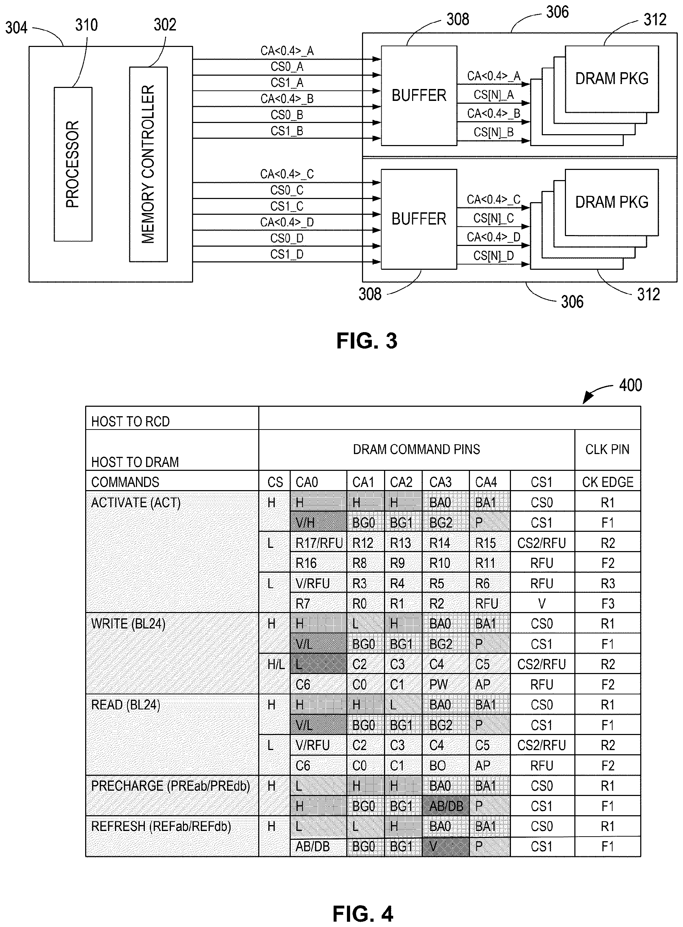

In FIG. 1, the memory controller 102 includes example command logic 112 and an example scheduler 114. The command logic 112 represents control logic that generates memory access commands and rank selections to be sent over a command bus 124 (CA) and CS signal lines 126 (CS0) and 128 (CS1) in response to the execution of operations by processor 108. In some examples, the control logic 112 may use the CS signal line 126 (CS0) to select rank 0 and the CS signal line 128 (CS1) to select rank 1. In some examples, the control logic 112 may use the CS signal line 126 and CS signal line 128 to select ranks 0-N. The control logic 112 is described in further detail below in connection with FIGS. 3, 4, 5, 6, 7, 8, 9, and 10.

The scheduler 114 represents logic or circuitry to generate and order transactions to send to memory channel 116. From example, the scheduler 114 schedules memory access and other transactions to memory channel 116. Such scheduling can include generating the transactions themselves to implement the requests for data by processor 108 and to maintain integrity of the data (e.g., such as with commands related to refresh). Transactions can include one or more commands, and result in the transfer of commands or data or both over one or multiple timing cycles such as over multiple clock cycles or unit intervals (UIs). Transactions can be for access, such as read or write, or related commands or a combination, and other transactions can include memory management commands for configuration, settings, data integrity, or other commands or a combination.

The memory controller 102 includes the scheduler 114 to allow selection and ordering of transactions to improve performance of the memory subsystem 100. Thus, memory controller 102 can select which of the outstanding transactions should be sent to memory channels 116A-D in which order, which is typically achieved with logic much more complex that a simple first-in first-out algorithm. The scheduler 114 and/or, more generally, the memory controller 102, manages the transmission of the transactions to memory channels 116A-D, and manages the timing associated with the transaction. In one embodiment, transactions have deterministic timing, which can be managed by the scheduler 114 and used in determining how to schedule the transactions.

The computing platform 104 includes the I/O interface 110 to couple the memory controller 102 to memory modules 106A, 106B. I/O interface 110 can include pins, pads, connectors, signal lines, traces, or wires, or other hardware to connect the devices, or a combination of these. I/O interface 110 can include a hardware interface. In some examples, the I/O interface 110 includes drivers/transceivers for signal lines 124, 126, and 128. Commonly, wires within an integrated circuit interface couple with a pad, pin, or connector to interface signal lines or traces or other wires between devices. I/O interface 110 can include drivers, receivers, transceivers, or termination, or other circuitry or combinations of circuitry to exchange signals on the signal lines between the devices.

In FIG. 1, the I/O interface 110 allows the memory controller 102 to access the groups of memory channels 116A-D in parallel. In the example of FIG. 1, the memory modules 106A and 106B include at least two ranks of DRAM devices 122 across the memory channels 116A-D. In such an example embodiment, the I/O interface 110 includes one command pin (CA) and two chip select (CS) pins per memory channel 116A-D. Previously, each rank on a memory module has a separate chip select line at the host (e.g., at the computing platform 104), labeled as CS0, CS1, etc. However, in examples disclosed herein, the I/O interface 110 and, more generally, the computing platform 104, has a maximum of two chip select lines and, thus, chip select pins, per memory channel 116, regardless of a number of ranks of DRAM packages 122 included in the memory channel 116.

In FIG. 1, a bus between memory controller 102 and memory module 106 can be implemented as multiple signal lines coupling memory controller 102 to memory modules 106. The bus may typically include command/address (CA) line 124 and chip select lines 126, 128. In some examples, the bus includes additional signal lines, including at least clock (CLK), write data (DQ) and read data (DQ), and other signal lines. In one embodiment, a bus or connection between memory controller 102 and memory can be referred to as a memory bus. The signal lines 124 for CA can be referred to as a "CA bus" (or ADD/CMD bus, or some other designation indicating the transfer of commands (C or CMD) and address (A or ADD) information). In one embodiment, independent memory channels 116A-D have different clock signals, CA buses (CA_A, CA_B, etc.), CS signals (e.g., CS0_A, CS0_B, CS1_A, CS1_B, etc.), data buses, and other signal lines. Thus, memory subsystem 100 can be considered to have multiple "buses," in the sense that an independent interface path can be considered a separate bus. It will be understood that in addition to the lines explicitly shown, a bus can include at least one of strobe signaling lines, alert lines, auxiliary lines, or other signal lines, or a combination. It will also be understood that serial bus technologies can be used for the connection between memory controller 102 and memory channels 116A-D. An example of a serial bus technology is 8B10B encoding and transmission of high-speed data with embedded clock over a single differential pair of signals in each direction. In one embodiment, CA 124 represents signal lines shared in parallel with multiple memory devices. In one embodiment, multiple memory devices 122 share encoding command signal lines of CA 124, and each rank of memory devices 122 has a separate chip select (CS_n) signal line in the memory module 106 to select ranks of individual memory devices 122.

In one embodiment, memory channels 116A-D and memory controller 102 exchange data over the data bus in a burst, or a sequence of consecutive data transfers. The burst corresponds to a number of transfer cycles, which is related to a bus frequency. In one embodiment, the transfer cycle can be a whole clock cycle for transfers occurring on a same clock or strobe signal edge (e.g., on the rising edge). In one embodiment, every clock cycle, referring to a cycle of the system clock, is separated into multiple unit intervals (UIs), where each UI is a transfer cycle. For example, double data rate transfers trigger on both edges of the clock signal (e.g., rising and falling). A burst can last for a configured number of UIs, which can be a configuration stored in a register, or triggered on the fly. For example, a sequence of eight consecutive transfer periods can be considered a burst length 8 (BL8), and each memory channel 116A-D can transfer data on each UI. Thus, a ×8 memory device operating on BL8 can transfer 64 bits of data (8 data signal lines times 8 data bits transferred per line over the burst). It will be understood that this simple example is merely an illustration and is not limiting.

In FIG. 1, the memory modules 106A, 106B include an input/output I/O interface 130. In some examples, the I/O interface 130 has a bandwidth determined by the implementation of the memory channels 116A-D (e.g., ×16 or ×8 or some other interface bandwidth). The I/O interface 130 enables the memory channels 116A-D to interface with the memory controller 102. The I/O interface 130 can include a hardware interface and can be in accordance with the I/O interface 110 of memory controller 102, but at the memory device end.

As mentioned above, the memory channels 116A-D may be referred to as memory devices 116A-D. In one embodiment, the memory devices 116A-D are connected in parallel to the same command and data buses. In another embodiment, the memory devices 116A-D are connected in parallel to the same command bus and are connected to different data buses. For example, the memory module 106A can be configured with memory devices 116A and 116B coupled in parallel, with each memory device 116A, 116B responding to a command, and accessing memory resources of DRAM packages 122 internal to each. In some examples, for a Write operation, an individual memory device 116A or 116B can write a portion of the overall data word, and for a Read operation, an individual memory device 116A or 166B can fetch a portion of the overall data word. In an example, a specific memory device 116A can provide or receive, respectively, 8 bits of a 128-bit data word for a Read or Write transaction, or 8 bits or 16 bits (depending for a ×8 or a ×16 device) of a 256-bit data word. The remaining bits of the word will be provided or received by other memory device 116B in parallel.

In FIG. 1, the memory devices 116A-D are organized into memory modules 106A and 106B. In one embodiment, memory modules 106A, 106B represent dual inline memory modules (DIMMs). In one embodiment, memory modules 106A, 106B represent other organization of multiple memory devices to share at least a portion of access or control circuitry, which can be a separate circuit, a separate device, or a separate board from the host system platform. Memory modules 106A, 106B can include multiple DRAM packages 122, and the memory modules 106A, 106B can include support for multiple separate channels 116A-D to the included DRAM packages 122 disposed on them.

In FIG. 1, the DRAM packages 122 include memory resources. Memory resources represent individual arrays of memory locations or storage locations for data. In some examples, as mentioned above, memory resources of DRAM packages 122 are managed as rows of data, accessed via wordline (rows) and bitline (individual bits within a row) control. The DRAM packages 122 may be organized as separate channels, ranks, and banks of memory.

In FIG. 1, the memory module 106 may be implemented as a specific type of DIMM. For example, the memory module 106 may be implemented as a buffered DIMM, which is a memory module with a device (e.g., a registering clock driver (RCD), integrated memory buffer (IMB), etc.) that buffers signals between a host memory controller 102 and the DRAM packages 122. Examples of registered DIMM (RDIMM), a load-reduction DIMM (LRDIMM), and a multiplexed rank DIMM (MRDIMM). In other examples, the memory module 106 may be implemented as an unbuffered DIMM (UDIMM), which is a memory module without a buffering device (e.g., no RCD 132). In FIG. 1, the memory modules 106A, 106B may be any type of memory module. In examples where the memory module 106A or 106B is implemented by a buffered DIMM, then the memory module 106A or 106B includes an example buffering device 132. In examples where the memory module 106A or 106B is not implemented by a buffered DIMM, the CA signal line 124 and the CS signal lines 126, 128 are directly coupled to the DRAM packages 122.

In FIG. 1, the buffering device 132 is a device that buffers signals between the memory controller 102 and the DRAM packages 122 and controls the timing and signaling to the DRAM packages 122. In some examples, a buffering device 132 may be a registering clock driver (RCD) or an integrated memory buffer (IMB). As used herein, the buffering device 132 may be referred to as an RCD. In some examples, the buffering device 132 may be in compliance with the DDR4 Registering Clock Driver Specification (DDR4RCD02 JESD82-31A), the DDR5 Registering Clock Driver Specification (DDR5RCD02 JESD82-512), or other RCD standards.

In some examples, the buffering device 132 includes hardware logic 134 that receives command and clock signals 124, 126, 128 from the memory controller 102. For example, the hardware logic 134 of the buffering device 132 captures at least two bit values from a CS signal line. In some examples, when operating in an encoded mode, the hardware logic 134 captures a multi-bit signal sent over two or more clock cycles. The hardware logic of the buffering device 132 regenerates the command and clock signals for forwarding to the DRAM packages 122 in accordance with relevant protocols and standard specifications. For example, the buffering device 132 may generate backside CA signals 118 and backside CS signals 120A, 120B, 120C, etc., that are sent to the DRAM packages 122. As used herein, "backside" CS and CA lines are the CS and CA signal lines going from buffering device 132 to DRAM packages 122. In contrast, "frontside" CS and CA lines are signal lines from the memory controller 102 to the buffering device 132. In some examples, the buffering device 132 includes a CS pin per rank of DRAM packages 122. For example, to provide a CS signal to each rank of DRAM packages 122, the buffering device 132 has a pinout (CS pin) for each CS signal.

In FIG. 1, the buffering device 132 includes the hardware logic 134 to train the backside CS and CA lines during a configuration of the memory subsystem 100, as well as decode bits on frontside CA lines 124 and frontside CS lines 126, 128 during operation in some examples. In some examples, the memory controller 102 configures the buffering device 132 and logic 134 at a start-up or system boot of the memory subsystem 100. In some examples, the memory controller 102 configures the buffering device 132 and logic 134 (e.g., instructs the buffering device 132 to enter into) in a toggle mode or an encoded mode, depending on the type of DIMM and on the number of ranks of DRAM packages 122. Toggle mode refers to a one-to-one mode, where the data on the frontside CS lines 126 and 128 can just be buffered to the corresponding backside CS lines 120A and 120B (e.g., where CS line 126 (CS0_A) corresponds to CS line 120A (CS0_A) and CS line 128 (CS1_A) corresponds to CS line 120B (CS1_A)). Encoded mode refers to encoding a chip select as a multi-bit signal, where multiple bits of data are sent on the frontside CS lines 126 and 128 in multiple unit intervals (UIs) and decoded by the buffering device 132 in order to identify which rank and, thus, which backside CS line is pulled high or low.

In some examples, when the memory modules 106A, 106B do not include buffering devices 132, the memory modules 106A, 106B still implement hardware logic 134. For example, the hardware logic 134 may be implemented by a difference portion of the memory modules 106A, 106B. In such an example, the hardware logic 134 receives bit values on one of the frontside CS lines 126 and 128 and buffers them to the backside CS lines 120A and 120B. In some examples, the hardware logic 134 determines which rank of DRAM packages 122 to enable based on the bit values from the frontside CS lines 126 and 128. For example, the hardware logic 134 buffers a value directly to the DRAM packages 122 to enable the rank of DRAM packages 122.

In FIG. 1, the computing platform 104 includes an example serial presence detect (SPD) device 136. The SPD device 136 is a hardware feature that makes it possible for the computing platform 104 to know what memory is present, as well as what memory timings to use to access the memory. For example, the SPD device 136 reads information from the memory modules 106A, 106B to determine whether the memory module is an RDIMM, UDIMM, MRDIMM, etc., and also to determine whether the memory channels 116A-D contain one rank, two ranks, three ranks, four ranks, etc. In some examples, the SPD device 136 can determine addressing, I/O width, bank groups and banks per bank group, etc. The SPD device 136 can inform the memory controller 102 of the memory module 116A, 116B type, as well as the number of ranks of DRAM packages 122 present in the memory module 116A, 116B. In some examples, the memory controller 102 uses the information from the SPD device 136 to generate commands, such as chip select signals, addressing signals, and other command signals.

While the memory subsystem 100 of FIG. 1 illustrates two memory modules 106A, 106B, the memory subsystem 100 may include any number of memory modules. For example, the computing platform 104 may be referred to as a socket, and a computing system may have up to 4 sockets (or computing platforms 104). Each socket may have communication channels that support 16 memory modules (DIMMs), 24 DIMMs, 32 DIMMs, or up to 48 DIMMs. As used herein, a communication channel is a physical data path between the socket (e.g., the computing platform 104) and the memory (e.g., memory modules 106). In some examples, each communication channel includes the CS signal lines, CA signal lines, and data signal lines. One communication channel can be used to control requests and data to and from 2 memory modules, 4 memory modules, 8 memory modules, etc. In a 2 rank DIMM, 8 chip selects are needed. For example, in a 2 rank (2R) memory module (DIMM), there are two chip select pins per DRAM die, and one DRAM package 122 of a 2R DIMM contains four dies, totaling to 8 CS pins for a 2R DIMM. In a 4 rank (4R) DIMM, there are 16 CS pins. In an 8 rank DIMM, there are 32 CS pins. In total, for a socket with a 2R DIMM count of 16, there are 128 CS pins at the host 104 (e.g., 16x8 CS pins = 128). A socket with a 4R DIMM count of 16 has 256 CS pins at the host (e.g., 16x16 CS pins = 256). A socket with an 8R DIMM count of 16 has 512 CS pins at the host (e.g., 16x32 CS pins = 512).

Examples disclosed herein reduce the number of chip select pins at the host (e.g., computing platform 104) and at the memory modules 106A, 106B. Examples disclosed herein reduce the CS pin count to 8 CS pins per 2 rank (2R) memory module (DIMM), 4R DIMM, 8R DIMM, etc. For example, the memory controller 102 uses 2 CS pins per DRAM die (and 4 per DRAM package 122) regardless of the memory rank. Therefore, the worst case scenario of pin count is for a 4 socket memory subsystem 100 that supports up to 48 DIMMs, which would total 1,536 CS pins across respective hosts 104 (e.g., 48x8 CS pins x 4 sockets = 1,536 CS pins). This worst case scenario for a pin count is 2x better than the worst case scenario for a pin count of conventional memory subsystems where 16 CS pins were needed for an 8R DIMM (e.g., 48x16x4 = 3,072 CS pins). A reduction of pin counts can improve memory subsystem communications, memory subsystem size and complexity, memory subsystem costs, etc.

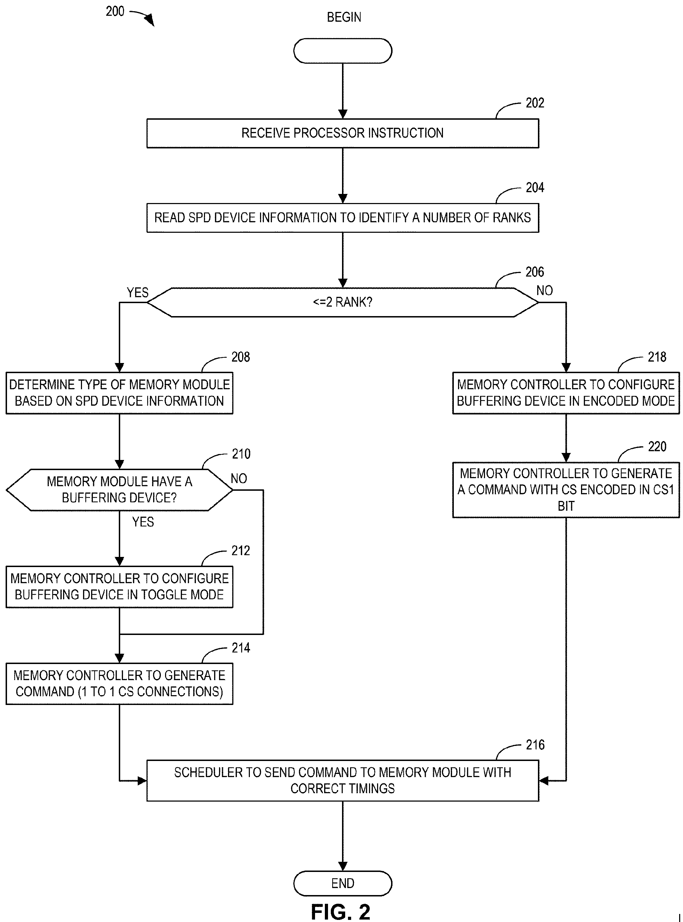

FIG. 2 is a flowchart representative of example machine readable instructions and/or example operations 200 that may be executed, instantiated, and/or performed by programmable circuitry to implement the memory controller 102 of FIG. 1. The example machine-readable instructions and/or the example operations 200 of FIG. 2 begin at block 202, at which the memory controller 102 (FIG. 1) receives a processor instruction. For example, the processor 108 (FIG. 1) sends a start-up instruction to the memory controller 102. In some examples, the start-up instruction causes the memory controller 102 to configure a memory module 106 (FIG. 1) to execute in a specified mode.

At block 204, the memory controller 102 reads information from the SPD device 136 to identify a number of ranks. For example, the memory controller 102 queries the SPD device 136 to determine whether the memory subsystem 100 includes 2 ranks, 3 ranks, 4 ranks, etc. In some examples, the SPD device 136 can identify signal, dual, or quad-rank configurations through the specifications of the memory module 106.

At block 206, the memory controller 102 determines whether the memory module 106 is less than or equal to 2 ranks (<=2 Rank). For example, the memory controller 102 identifies, through the SPD device 136, whether the memory modules 106 are signal or dual rank modules, or whether the memory modules 106 have a higher number of ranks. This is because the number of ranks determines what type of mode the memory controller 102 is to operate in when generating CS signals.

At block 208, when the memory controller 102 determines that the memory module 106 is less than or equal to 2 ranks (e.g., block 206 returns a value YES), the memory controller 102 determines the type of memory module 106 based on information from the SPD device 136. For example, the memory controller 102 reads the SPD device 136 to determine whether the memory module 106 is implemented as a buffered DIMM or unbuffered DIMM.

At block 210, the memory controller 102 determines whether the memory module 106 has a buffering device. A buffering device is a register on the memory module 106 used to configure and control operational parameters of the DRAM packages 122 on the memory module 106. If the memory module 106 is a buffered DIMM, then the memory module 106 includes a buffering device. If the memory module 106 is an unbuffered DIMM, then the memory module 106 does not include a buffering device.

At block 212, when the memory controller 102 determines that the memory module 106 does have a buffering device (e.g., block 210 returns a value YES), the memory controller 102 configures the buffering device in toggle mode. For example, the memory controller 102 configures the buffering device 132 (FIG. 1) to buffer the data on the frontside CS lines 126 (FIG. 1) and 128 (FIG. 1) to the corresponding rank of memory packages on backside CS lines 120A (FIG. 1) and 120B (FIG. 1). In this example, the buffering device 132 does not have to decode signals sent on the CS line, because there is a one-to-one relationship between the frontside CS line and the backside CS line.

At block 214, the memory controller 102 is to generate chip select commands (1 to 1 CS connections). For example, in a 2R memory module 106, the command logic 112 (FIG. 1) is to toggle CS0 and CS1 to select the first rank or the second rank. In some examples, when the memory controller 102 determines that the memory module 106 does not have a buffering device (e.g., block 210 returns a value NO), control turns to block 214. For example, there is no buffering device for the memory controller 102 to configure and, thus, the direct coupling of the frontside CS lines with the backside CS lines enables the command logic 112 to generate CS commands without having to configure buffering device 132.

At block 216, the memory controller 102 sends the command to memory module 106 with correct timings. For example, the scheduler 114 (FIG. 1) may transfer the command over one or multiple timing cycles, such as clock cycles or unit intervals (UIs). In this example, because there is only 2R of data and the memory controller 102 is operating in toggle mode or direct 1 to 1 connection, the scheduler 114 sends the CS command over one UI.

Returning to block 206, when the memory controller 102 determines that the memory module 106 is greater than 2 ranks (e.g., block 206 returns a value NO), the memory controller 102 configures the buffering device 132 in encoded mode. The memory controller 102 does not have to determine the type of memory module 106 when the rank is greater than 2, because any DIMM with 3+ ranks needs a buffering device 132. This is due to the higher load on the CA signals in order to read, write, address, etc., to the multiple ranks. The buffering device 132 may re-time the signals from the memory controller 102, ensuring signal integrity and reducing any strain on the memory controller 102. The encoded mode instructs the buffering device 132 that the CS signals will be encoded, and that decoding will be necessary to identify the correct CS that is being selected. In some examples, when the memory controller 102 configures the buffering device 132 in encoded mode, the buffering device 132 receives CS data over multiple UIs. As such, the buffering device 132 may wait a certain number of UIs to perform a decoding operation. For example, the buffering device 132 collects data from the CS signal lines over 2 or more UIs, and then performs a decoding operation to identify which rank and, thus, which backside CS line to pull high or low.

At block 220, the memory controller 102 generates a command with CS encoded in CS1 bit. For example, the memory controller 102 generates a multi-bit command signal that is to be sent on the second CS signal line (CS1_A, or CS1_B, etc.) over multiple UI. In some examples, the memory controller 102 can select up to rank 4 using 2 bits sent over 2 UIs. In some examples, the memory controller 102 can select up to rank 8 using 3 bits sent over 3 UIs. In some examples, the memory controller 102 can select up to rank 16 using 4 bits sent over 4 UIs.

At block 216, the memory controller 102 sends the command to the memory module 106 with correct timings. For example, the scheduler 114 sends the encoded command on the second CS signal line over multiple UIs.

The operations 200 end when the memory controller 102 sends the CS command to the memory module 106. In some examples, when the memory controller 102 identifies the rank number and the DIMM type, the memory controller 102 does not need to repeat reading the SPD device information before generating the CS command. Therefore, the memory controller 102 can skip blocks 204, 206, 208. 210, 212, and 218 when the next processor instruction comes in.

FIG. 3 is an example first system 300, representing an example embodiment of the memory subsystem 100 of FIG. 1. The first system 300 includes an example memory controller 302 of an example host 304, example memory modules 306, and example buffering devices 308. The host 304 includes an example processor 310. The memory modules 306 include example DRAM packages 312.

The first system 300 illustrates a high-level computing and memory architecture of the CA and CS signal lines of the system 300 when the memory modules 306 are buffered memory modules 306. In FIG. 3, the memory controller 302 configures the buffering devices 308 in a toggle mode or an encoded mode based on the number of ranks in the memory modules 306. In the example embodiment, there is a command bus (CA bus) for each memory channel, where the memory modules 306 of FIG. 3 have two memory channels each (A/B, and C/D) and, thus, two command busses (CA busses). However, the system 300 may have any number of memory modules 306 and the memory modules 306 may have any number of memory channels.

In the example embodiment of FIG. 3, the CA busses are 5 bits in length, meaning that 5 command bits are sent during 1 UI. To implement 5 command bits, there are 5 command pins at the host 304 and 5 CA signal lines on the CA bus. In some examples, the 5 CA signal lines are referred to as CA0, CA1, CA2, CA3, and CA4. The memory controller 302 controls what bits are sent on the CA signal lines and at what times. The buffering device 308 is configured to receive the information on the CA lines and send them to the memory modules 306.

In the example embodiment of FIG. 3, there are two chip select pins for each memory channel, CS0 and CS1, notwithstanding the number of ranks per memory module 306. The CS signals are 1 bit signals, meaning that one bit is sent on the CS line during a UI. In the example embodiment of FIG. 3, there is a total of 8 CS pins at the host 304, as well as 8 CS pins at the front side of the buffering device 308. The memory controller 302 eliminates the need for more CS pins at the host 304 and at the front side of the buffering device 308 when there are more than 2 ranks of memory devices. For example, in a 4 rank memory module, 2 extra CS pins are traditionally needed at the host 304 for ranks 3 and 4. As such, 16 CS pins would be needed at the host 304 and at the front side of the buffering device 308 for the two memory modules 306 having two memory channels each and 4 ranks per memory channel.

The number of CS pins at the back side of the buffering device 308, however, is not reduced. For example, depending on the number of ranks in the memory modules 306, the backside of the buffering device 308 may include more than 8 CS pins. For example, in a 2R memory module, the back side of the buffering device 308 includes 2 CS pins per subchannel (e.g., Channel A, Channel B, etc.) times the number of subchannels within the DIMM. In a 4R memory module, the back side of the buffering device 308 includes 4 CS pins per memory subchannel.

In the example of FIG. 3, the buffering devices 308 may be RCD devices. Alternatively, the buffering devices 308 may be integrated memory buffers (IMB). In the example of FIG. 3, the DRAM packages 312 may be DDR6 packages. Alternatively, the DRAM packages 312 may be DDR5 packages, DDR4 packages, etc. The memory controller 302 may include some, all, or more of the components included in the memory controller 102 of FIG. 1. For example, the memory controller 302 may include command logic and a scheduler.

In an example operation, the processor 310 makes a request for an access to the memory module 306. The memory controller 302 receives the request and determines which rank of memory the request is intended for. For example, the processor 310 may want to read from or write data to an address in one of the memory modules 306 and/or more specifically, in one of the DRAM packages 312. The memory controller 302 determines that the memory module 306 is a 4R memory module 306, and has already configured the buffering device 308 in encoded mode. The memory controller 302 determines that the processor 310 has instructed to write data to a row in rank 3. The memory controller 302 generates a multi-bit signal that selects the third rank of DRAM packages 312. In some examples, generating a multi-bit signal may be referred to as "encoding a chip select." The memory controller 302 also generates the write command for a specific row in rank 3 DRAM packages 312. The memory controller 302 then transmits the multi-bit signal on the CS1 signal line over two UIs. The buffering device 308 obtains the information on the CS1 signal line and regenerates the CS commands to be sent over the back side of the buffering device 308 to the appropriate rank of DRAM packages 312. The regenerated CS command is to enable the rank 3 DRAM packages in preparation for the write command sent on CA bus.

FIG. 4 illustrates an example DRAM truth table 400 that corresponds to the embodiment of FIG. 3. The DRAM truth table 400 may be used by the buffering device 308 to determine which rank of memory to enable, as well as which command to facilitate. The truth table 400 has COMMAND pins which include CS, CA0, CA1, CA2, CA3, CA4, CA5, and CS1. The truth table 400 also has commands, which include ACTIVATE, WRITE, READ, PRECHARGE, and REFRESH. The truth table 400 also has a clock pin (CLK PIN), which outputs clock cycles.

The signals sent on the COMMAND pins and CLK pin include: H (High); L (Low); BAx (Bank Address x); BGx (Band Group x); V (High or Low); Rx (Row Address bit x); Cx (Column Address bit x); AB (command applied to All Banks, bank address is don't care); DB (command applied to Dual Banks); AP (AP "HIGH" during WRITE, MASK WRITE or READ commands indicates that an Auto-Precharge will occur to the bank associated with the WRITE, MASK WRITE or READ command); H/L (target or non-target write command); PW (Partial Write); P (Parity); V (Valid); RFU (Reserve for Future Usage); CSx (Chip Select bit x); Rn (Rising clock edge n); and Fn (Falling clock edge n).

In examples disclosed herein, since there will only be two chip select pins for a memory channel, the CS1 command pin has two extra bits CS1 and CS2, totaling 3 bits for the CS1 command pin. In the truth table 400, the CS1 pin has more than 3 bits, for example, in the ACTIVATE command table. The extra bits, referred to as RFU, may be reserved for memory modules 306 having greater than 8 ranks of memory. For example, the memory controller 302 may use the extra bits to encode CS for a memory module having 12 ranks, 16 ranks, etc.

To explain how encoding the chip select in the CS1 pin works, description will begin with how chip select is used by a memory controller. Memory controllers, such as memory controller 102 and memory controller 302, uses the chip select signal for controlling specific ranks of DRAM packages (e.g., DRAM packages 122 and DRAM packages 312) during memory operations, such as ACTIVATE, READ, WRITE, PRECHARGE, and REFRESH. The memory controller (e.g., 102, 302) issues three basic commands as part of a DRAM read or write operation: 1) the ACTIVATION (ACT) command, which senses and amplifies the data from the target row into the row buffer; 2) the READ/WRITE (RD/WR) command, which transfers data from/to the row buffer to/from the DRAM bus; and 3) the PRECHARGE (PRE) command, which clears the row buffer and prepares the subarray for subsequent read/write operations (precharges the bitlines).

Each rank of DRAM packages 312 has a dedicated CS signal CS[0]-CS[N]. When the memory controller 302 asserts the CS signal for a specific rank (CS[0] for rank 0], the memory controller 302 selects that rank for the subsequent command (ACTIVATE, READ, WRITE, PRECHARGE, OR REFRESH). The CS signal, combined with other command signals from the memory controller 302, such as the address and command and address parity signals, dictate the intended memory operation. The memory device, such as the buffering device 308 and/or the DRAM packages 312, receives a combination of CS signal and command encoding on the command bus and CS signal lines to trigger a specific memory operation.

For example, to activate a row in a bank (BA), the CS signal for the desired rank is asserted, along with the correct row and bank address signals. The CS signal to DRAM command pins is 2 cycle command instead of single cycle. This means that the CS COMMAND pin will be high (H) or low (L) for 2 unit intervals (UI). The CS1 COMMAND pin will not be just high (H) or low (L) for 2 UIs. In some examples, on a first UI, CS1 COMMAND pin is high (H) and on the second UI, CS1 COMMAND pin is low (L) to select a desired rank. However, the values of CS1 COMMAND pin may be either or depending on which rank and which mode the memory controller 302 is operating in (e.g., encoded mode or toggle mode). The ACTIVATE command, along with high or low on the CS_N pin, determines the command functionality. In another example, when initiating a READ or WRITE operation, the memory controller 302 asserts a CS signal to select the target rank, and provides the column address along with the READ or WRITE command. In another example, the memory controller 302 may provide a value for Auto-Precharge or Precharge. The Precharge command deactivates an open row (or closes it) in one or all banks. The CS signal indicates the target bank(s). After precharging, the bank is in an idle state and requires an ACTIVATE command before a READ or WRITE operation can be performed. Auto-Precharge automatically closes the currently accessed page, which can speed up the next access to the same bank. The memory controller 302 may decide whether to issue an Auto-Precharge READ or WRITE command based on the pending commands and the incoming command.

In some examples, the memory controller 302 selects the chip select based on sending high and low signals on the CS1 pin over multiple UIs. For example, the memory controller 302 generates a binary multi-bit value, where each bit corresponds to signals CS0, CS1, and/or CS2 on the CS1 pin. For example, CS0 is the most significant bit and CS1 or CS2 (depending on how many ranks there are) is the least significant bit. The memory controller 302 toggles the binary values in toggle mode to generate the ship select. Table 1 below illustrates one possible example of how the memory controller 302 encodes a chip select, for a 4R memory module, using the CS0 and CS1 signals on the CS1 pin.

**TABLE 1: 4R Truth Table**

| **CS0** | **CS1** | **Rank #** |
|---|---|---|
| 0 | 0 | Rank 0 |
| 0 | 1 | Rank 1 |
| 1 | 0 | Rank 2 |
| 1 | 1 | Rank 3 |

Table 1 may represent a truth table, used by the buffering device 308, to determine which rank to enable. However, the memory controller 302 and the buffering device 308 may use any other combination of bit values to encode and decode the chip select. In some examples, the memory controller 302 sends CS0 signal first, on the first rising clock edge (R1) and CS1 signal second, on the first falling clock edge (F1), where the first rising clock edge occurs on a first UI and the first falling clock edge occurs on a second UI.

Table 2 below illustrates one possible example of how the memory controller 302 encodes a chip select, for an 8R memory module, using the CS0, CS1, and CS2 signals on the CS1 pin. In this example, CS2 is the least significant bit.

**TABLE 2: 8R Truth Table**

| **CS0** | **CS1** | **CS2** | **Rank #** |
|---|---|---|---|
| 0 | 0 | 0 | Rank 0 |
| 0 | 0 | 1 | Rank 1 |
| 0 | 1 | 0 | Rank 2 |
| 0 | 1 | 1 | Rank 3 |
| 1 | 0 | 0 | Rank 4 |
| 1 | 0 | 1 | Rank 5 |
| 1 | 1 | 0 | Rank 6 |
| 1 | 1 | 1 | Rank 7 |

Table 2 may represent a truth table, used by the buffering device 308, to determine which rank to enable. However, the memory controller 302 and the buffering device 308 may use any other combination of bit values to encode and decode the chip select. In some examples, the memory controller 302 sends CS0 signal first, on the first rising clock edge (R1), CS1 signal second, on the first falling clock edge (F1), and CS2 signal third, on the second rising clock edge (R2), where the first rising clock edge occurs on a first UI, the first falling clock edge occurs on a second UI, and the second rising clock edge occurs on a third UI.

In some examples, the memory module 306 is a 2R memory module. In such an example, the memory controller 302 configures the buffering device 308 in a toggle mode, as opposed to an encoded mode. The toggle mode indicates that the memory controller 302 will toggle the CS0 and CS1 signals on the CS1 pin to indicate the chip select. For example, Table 3 below illustrates how the memory controller 302 toggles the chip select, for a 2R memory module 306, using the CS0 and CS1 signals on the CS1 pin.

**TABLE 3: 2R Truth Table**

| **CS0** | **CS1** | **Rank #** |
|---|---|---|
| 1 | 0 | Rank 0 |
| 0 | 1 | Rank 1 |

Table 3 may represent a truth table, used by the buffering device 308, to determine which rank to enable. As shown in Table 3, to select Rank 0, a logic high (H or 1) is sent on the CS0 signal and a logic low (L or 0) is sent on the CS1 signal. To select Rank 1, a logic low (L or 0) is sent on the CS0 signal and a logic high (H or 1) is sent on the CS1 signal. In some examples, the bit values may be reversed, where to enable a chip select, the CS is to be pulled low, and to disable a chip select, the CS is to be pulled high. In such an example, the Table 3 truth table will be reversed, where to select Rank 0, the memory controller 302 toggles CS0 low and CS1 high. To select Rank 1, the memory controller 302 toggles CS0 high and CS1 low.

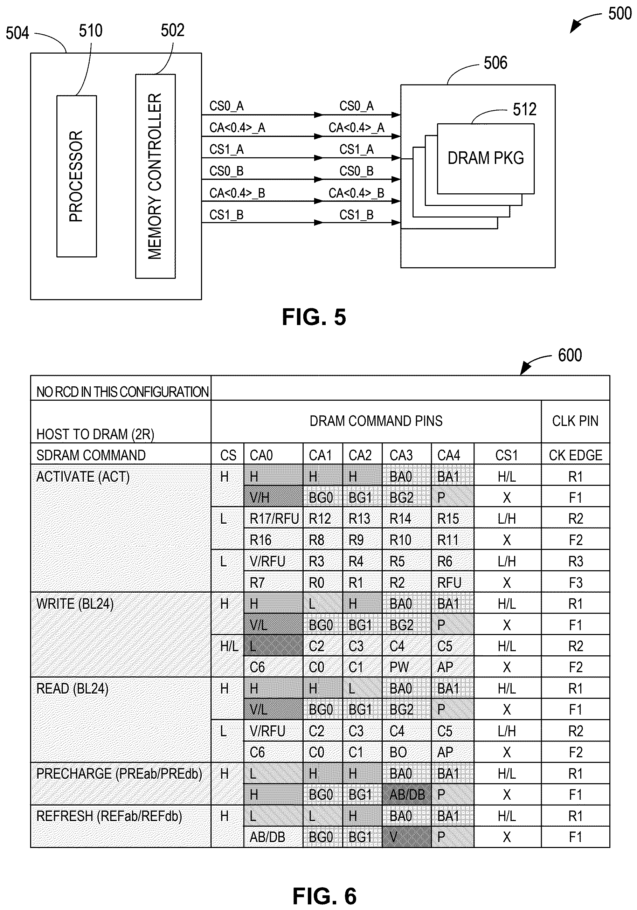

FIG. 5 is an example second system 500, representing an example embodiment of the memory subsystem 100 of FIG. 1. The second system 500 illustrates an unbuffered memory module 506, where a memory controller 502 is directly connected to the memory module 506. The system 500 includes the example memory controller 502, an example host 504, the example memory module 506, an example processor 510, and example DRAM packages 512.

In FIG. 5, the system 500 illustrates a single memory module 506. The memory module 506 includes two channels, channel A and channel B. As such, the host 504 includes two command pins for two command busses (CA_A bus and CA_B bus). Also, the host 504 includes four chip select pins for the four chip select signal lines (CS0_A, CS1_A, CS0_B, CS1_B).

In FIG. 5, the memory controller 502 does not have to configure a buffering device in a certain mode. Instead, the memory controller 502 determines how many ranks of DRAM packages 512 are in the memory module 506, and generates chip selects accordingly. In some examples, a memory system without a buffering device, such as the system 500, does not have more than two ranks of DRAM packages 512. This is because a memory module with more than two ranks of DRAM packages requires a buffering device to control the increased amounts of data sent from the host to the memory devices. Therefore, the memory controller 502 determines whether there is 1 rank or 2 ranks.

The memory controller 502 generates chip selects in toggle mode if the memory module 506 is a 2R. The memory controller 502 generates chip select using H or L on the CS0 pin if the memory module 506 is a single rank. In some examples, in a single rank memory system, the second chip select signal line (CS1) is not wired between the host and the memory module 506, because the second CS signal line is not needed.

In the example of FIG. 5 the DRAM packages 512 may be DDR6 packages. Alternatively, the DRAM packages 512 may be DDR5 packages, DDR4 packages, etc. The memory controller 502 may include some, all, or more of the components included in the memory controller 102 of FIG. 1. For example, the memory controller 502 may include command logic and a scheduler.

In an example operation, the processor 510 makes a request for an access to the memory module 506. The memory controller 502 receives the request and determines which rank of memory the request is intended for. For example, the processor 510 may want to read from or write data to an address in the memory module 506 and/or more specifically, in one of the DRAM packages 512. The memory controller 502 determines that the memory module 506 is a 2R memory module 306. The memory controller 502 determines that the processor 510 has instructed to write data to a row in rank 0. The memory controller 502 generates a command on the CS0 signal line that selects the first rank of DRAM packages 512. In some examples, the signal is a high or low signal. The memory controller 502 also generates the write command for a specific row in rank 0 DRAM packages 512. The memory controller 502 then transmits the signal on the CS0 signal line. In some examples, the memory controller 502 does not generate any signal for the CS1 signal line, because the memory controller 502 wants to enable rank 0. The memory module 506 obtains the information on the CS0 signal line and forwards the CS command to the appropriate rank of DRAM packages 512. The CS command is to enable the rank 0 DRAM packages in preparation for the write command sent on CA bus.

FIG. 6 illustrates an example DRAM truth table 600 that corresponds to the embodiment of FIG. 5. The DRAM truth table 600 may be used by the memory module 506 to determine which rank of memory in a 2R memory module 506 to enable, as well as which command to facilitate. The truth table 600 has COMMAND pins which include CS0, CA0, CA1, CA2, CA3, CA4, CA5, and CS1. The truth table 600 also has commands, which include ACTIVATE, WRITE, READ, PRECHARGE, and REFRESH. The truth table 600 also has a clock pin (CLK PIN), which outputs clock cycles.

The difference between the truth table 400 and truth table 600 lies in the signals sent on the CS0 command pin and the CS1 command pin. When there is not a buffering device, such as buffering device 308 of FIG. 3, the memory controller 502 operates as normal, where high (H) and low (L) signals are sent on the CS lines to enable and disable ranks of DRAM. The CS1 command pin therefore does not have extra bits to use for chip select. Another difference between the truth table 400 and the truth table 600 is that the CS command is sent over 1 UI. For example, one clock cycle is used to enable rank 0 or rank 1 of the memory module 506.

Examples disclosed herein therefore facilitate chip select for memory modules having no buffering device and two ranks or less of DRAM packages. For example, the proposed architecture for the host (e.g., the socket), which has a reduced number of CS pins relative to current memory architecture for 4+ ranks of memory devices, can still be implemented for two or less ranks of memory devices.

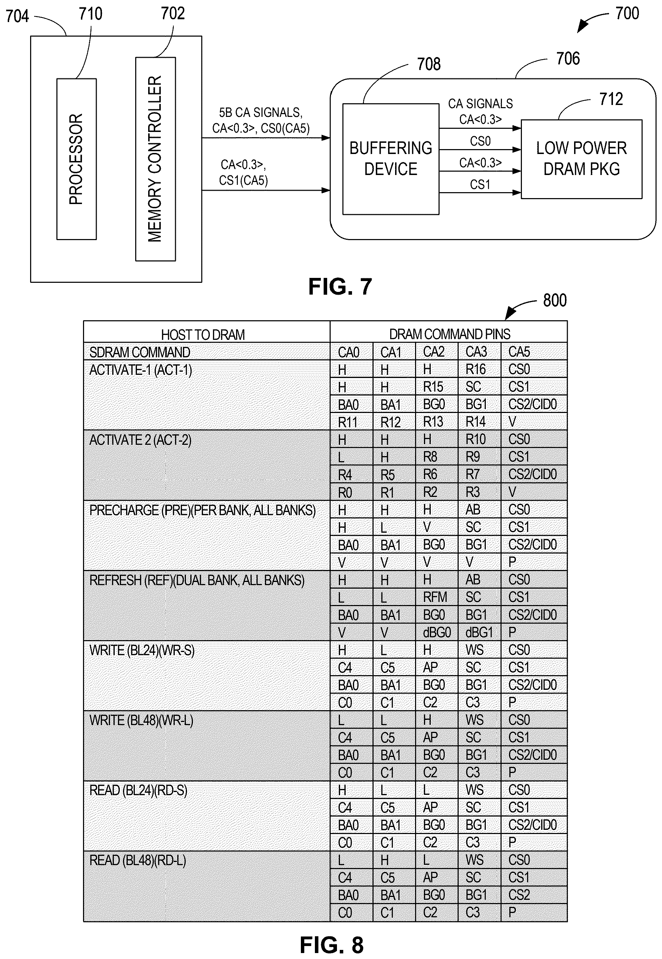

FIG. 7 is an example third system 700, representing an example embodiment of the memory subsystem 100 of FIG. 1. The third system 700 illustrates a buffered memory module 706 implementing a low power DRAM package 712. The system 700 includes an example memory controller 702, an example host 704, the example memory module 706, an example processor 710, and the example low power (LP) DRAM package 712.

In the example of FIG. 7, the buffering device 708 may be an RCD device. Alternatively, the buffering device 708 may be an IMB. In the example of FIG. 7, the DRAM package 712 may be an LP DDR6 package. Alternatively, the DRAM package 712 may be an LP DDR5 package, LP DDR4 package, etc. The memory controller 702 may include some, all, or more of the components included in the memory controller 102 of FIG. 1. For example, the memory controller 702 may include command logic and a scheduler.

The embodiment of FIG. 7 provides a flexibility to use low power DRAM, such as LPDDR6, or regular DRAM, such as DDR6, behind the buffering device 708. This provides an advantage for server systems to save power versus increased reliability, accessibility, and serviceability (RAS). RAS refers generally to features that enable the system 700 to handle errors to continue to operate. In some examples, using LP DRAM may be considered for artificial intelligence (AI) systems, because AI systems need higher bandwidth memory, higher capacity, but lower power consumption.

In some examples, the command bus for an LP DRAM 712 has fewer command (CA) pins per channel than regular power DRAMs. For example, the host 704 includes 4 command pins per channel, as opposed to 5 command pins for a DDR6 package (e.g., as shown in FIGS. 3 and 5). Also, when implementing an LP DRAM behind the buffering device 708, there is one chip select pin per command bus. In this example, there are two CA busses and a CS pin per CA bus.

In FIG. 7, the CS pins are referred to as the "fifth command pin" or "CA5 pin". This is to show that the memory controller 702 may treat the CS pin like a command pin when the memory module 706 has more than two ranks of LP DRAM packages 712. For example, the memory controller 702 can select up 8 ranks or more using the CS pin, by encoding the chip select in a CS signal and sending the CS signal over multiple UIs. Also, the CS pin may be referred to as the "CA5 pin" because the CS command is sent over the command bus.

In the example embodiment of FIG. 7, the buffering device 708 uses a low power DRAM command truth table, where the truth table is configured with an extra command pin (CA5) for a CS encoding bit.

For example, turning to FIG. 8, an example LP DRAM truth table 800 is illustrated that corresponds to the embodiment of FIG. 7. The LP DRAM truth table 800 may be used by the memory module 706 to determine which rank of memory in a 2R, 4R, 8R, 16R, etc., memory module 706 to enable, as well as which command to facilitate. The truth table 800 has COMMAND pins which include CA0, CA1, CA2, CA3, and CA5 (also referred to as CS). The truth table 800 also has commands, which include ACTIVATE-1, ACTIVATE-2, PRECHARGE, REFRESH, WRITE (WR-S), WRITE (WR-L), READ (RD-S), and READ (RD-L).

In the case of an LP DRAM, the ACTIVATE command requires more than one clock cycle to complete, hence the ACT-1 and ACT-2 memory commands. For example, an ACTIVATE command is four cycles but could be considered two contiguous two-cycle commands, referred to as ACT-1 and ACT-2. In some examples, ACT-1 must be followed by ACT-2 for the same bank. Also, in the case of an LP DRAM, there are two types of WRITE commands and two types of READ commands. The WR/RD-S command is for a burst length BL24. The WR/RD-L command is for a longer burst length BL48.

The example command truth table 800 is similar to the command truth table 400 of FIG. 4. For example, there is one CS command pin that has two extra bits (CS1 and CS2) for encoding chip select. The memory controller 702 may use the extra bits to encode CS for a memory module having four ranks, eight ranks, twelve ranks, sixteen ranks, etc.

In some examples, the memory controller 702 encodes the chip select for a 4R memory module using the CS0 and CS1 signals on the CA5 command pin and the Table 1 above. In some examples, the memory controller 702 toggles the chip select for an 8R memory module using the CS0, CS1, and CS2 signals on the CA5 command pin and the Table 2 above. In some examples, the memory controller 702 toggles the chip select for a 2R memory module using the CS0 and CS1 signals on the CA5 command pin and the Table 3 above.

In some examples, the buffering device 708 decodes the CS details, based on any of Tables 1, 2, and/or 3, and generates CS behind the buffering device 708. The buffering device 708 sends the regenerated CS to the LP DRAM 712. In such an example, the pin out for the LP DRAM 712 does not need to be changed, no matter how many ranks of memory devices are included.

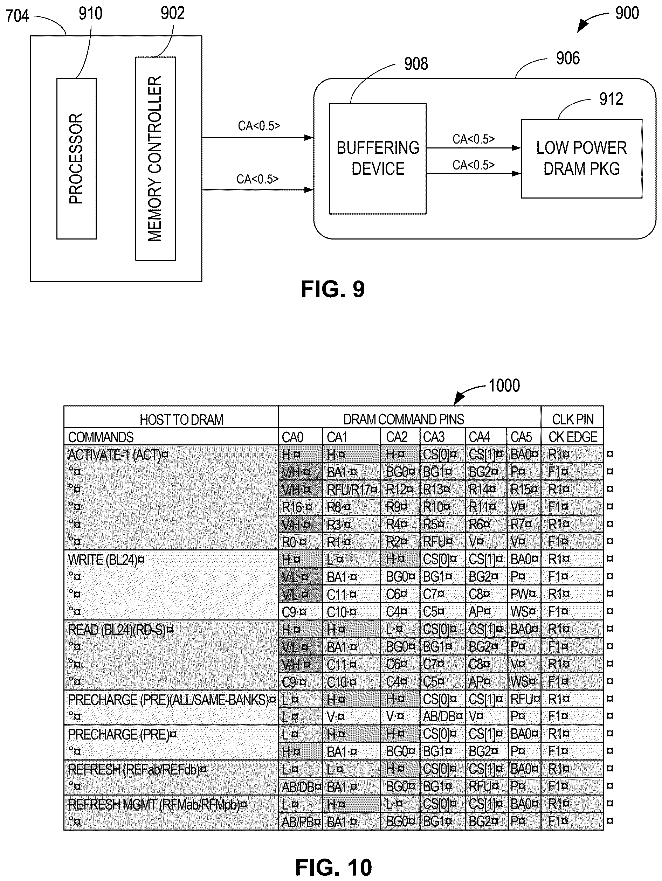

FIG. 9 is an example fourth system 900, representing an example embodiment of the memory subsystem 100 of FIG. 1. The fourth system 900 illustrates a buffered memory module 906 where all the commands, including a chip select command, are implemented on the command bus. The system 900 includes an example memory controller 902, an example host 904, an example memory module 906, an example buffering device 908, an example processor 910, and an example DRAM package 912.

In FIG. 9, the memory module 906 may be implemented by an RDIMM and/or an MRDIMM. Alternatively, the memory module 906 may be implemented by a UDIMM. The buffering device 908 may be implemented by an RCD. Alternatively, the buffering device 908 may be implemented by an IMB. The DRAM package 912 may be implemented by a DDR6 package. Alternatively, the DRAM package 912 may be implemented by a DDR5, DDR4, etc. In the example of FIG. 3, the buffering devices 308 may be RCD devices. Alternatively, the buffering devices 308 may be integrated memory buffers (IMB). The memory controller 902 may include some, all, or more of the components included in the memory controller 102 of FIG. 1. For example, the memory controller 902 may include command logic and a scheduler.

The system 900 is implemented to reduce the pin count at the host 904. Putting the chip select in the commands reduces the pin count because there are no pins needed for chip select. The memory controller 902 encodes the chip select on two of the command pins. For example, on command (CA) pins four and five, the memory controller 902 sends CS signals on one of the UIs. To ensure that the chip select commands are not diminishing or minimizing the other commands, such as activating a particular bank and row, or writing to a particular bank, the host 904 is provided with an additional command pin. For example, the CA bus is 6 bits instead of 5. The memory controller 902 may send command signals on the additional command pin. Adding the additional command pin still saves the pin count at the host 904 and at the buffering device 908.

In some examples, the memory module 906 does not include a buffering device 908, such that the memory controller 902 and the memory module 906 and/or the DRAM package 912 are configured to encode and decode the commands sent on the command pins, including the chip select. For example, in a 1R or 2R memory module 906, the host 904 and, thus, the memory controller 902, is directly coupled to the DRAM package 912. In such an example, the DRAM package 912 can decode the information on the fourth and fifth command pins corresponding to the chip select. In some examples, the DRAM package 912 does not have to decode, but instead is directly coupled to the fourth and fifth command pins and will activate particular ranks based on the values of the fourth and fifth command pins. For example, the CS signal on the fourth command pin may be coupled to a first rank of the DRAM package 912, and the fifth command pin may be coupled to a second rank of the DRAM package 912. Therefore, the DRAM die with the active CS signal will respond to the read, write, precharge, etc., commands.

FIG. 10 illustrates an example DRAM truth table 1000 that corresponds to the embodiment of FIG. 9. The DRAM truth table 1000 may be used by the memory module 906 to determine which rank of memory, in a 2R or 4R, memory module 906 to enable, as well as which command to facilitate. The truth table 1000 has COMMAND pins which include CA0, CA1, CA2, CA3, CA4, and CA5. The truth table 1000 also has a CLOCK pin. The truth table 1000 also has commands, which include ACTIVATE, PRECHARGE, REFRESH, WRITE, and READ.

The memory controller 902 reserves bits on the fourth command pin (CA3) and the fifth command pin (CA4) for the chip select signals (CS signals). For example, CS[0] is a first CS signal sent on the CA3 pin and over the first UI of each command type. Similarly, CS[1] is a second CS signal sent on the CA4 pin and over the first UI of each command type.

In some examples, when there are more than two ranks of memory devices, the memory controller 902 may operate in the encoded mode to encode chip select on the fourth and fifth command pins. For example, the memory controller 902 uses Table 1 above to encode the chip select for a 4R memory module 906. In some examples, when there are two or less ranks of memory devices, the memory controller 902 operates in the toggle mode to perform chip select. For example, the memory controller 902 uses Table 3 above to toggle the chip select for a 2R memory module 906.

While an example manner of implementing the memory subsystem 100 of FIG. 1 is illustrated in FIGS. 3, 5, 7, and 9, one or more of the elements, processes, and/or devices illustrated in FIGS. 3, 5, 7, and 9 may be combined, divided, re-arranged, omitted, eliminated, and/or implemented in any other way. Further, the example memory controller 102, the example computing platform 104, the example memory modules 106, the example processor 108, the example I/O device 110, the example I/O device 130, the example command logic 112, the example scheduler 114, the example buffering devices 132, the example logic 134, and/or, more generally, the example memory subsystem 100 of FIG. 1, may be implemented by hardware alone or by hardware in combination with software and/or firmware. Thus, for example, any of the example memory controller 102, the example computing platform 104, the example memory modules 106, the example processor 108, the example I/O device 110, the example I/O device 130, the example command logic 112, the example scheduler 114, the example buffering devices 132, the example logic 134, and/or, more generally, the example the example memory subsystem 100 of FIG. 1, could be implemented by programmable circuitry, processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), vision processing units (VPUs), and/or field programmable logic device(s) (FPLD(s)) such as FPGAs in combination with machine readable instructions (e.g., firmware or software). Further still, the example memory subsystem 100 of FIG. 1 may include one or more elements, processes, and/or devices in addition to, or instead of, those illustrated in FIG. 1, and/or may include more than one of any or all of the illustrated elements, processes and devices.

A flowchart representative of example machine readable instructions, which may be executed by programmable circuitry to implement and/or instantiate the memory controller 102 of FIG. 1 and/or representative of example operations which may be performed by programmable circuitry to implement and/or instantiate the memory controller 102 of FIG. 1, is shown in FIG. 2. The machine readable instructions may be one or more executable programs or portion(s) of one or more executable programs for execution by programmable circuitry and/or may be one or more function(s) or portion(s) of functions to be performed by the example programmable circuitry (e.g., an FPGA). In some examples, the machine readable instructions cause an operation, a task, etc., to be carried out and/or performed in an automated manner in the real world. As used herein, "automated" means without human involvement.

The program may be embodied in instructions (e.g., software and/or firmware) stored on one or more non-transitory computer readable and/or machine readable storage medium such as cache memory, a magnetic-storage device or disk (e.g., a floppy disk, a Hard Disk Drive (HDD), etc.), an optical-storage device or disk (e.g., a Blu-ray disk, a Compact Disk (CD), a Digital Versatile Disk (DVD), etc.), a Redundant Array of Independent Disks (RAID), a register, ROM, a solid-state drive (SSD), SSD memory, nonvolatile memory (e.g., electrically erasable programmable read-only memory (EEPROM), flash memory, etc.), volatile memory (e.g., Random Access Memory (RAM) of any type, etc.), and/or any other storage device or storage disk. The instructions of the non-transitory computer readable and/or machine readable medium may program and/or be executed by programmable circuitry located in one or more hardware devices, but the entire program and/or parts thereof could alternatively be executed and/or instantiated by one or more hardware devices other than the programmable circuitry and/or embodied in dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a human and/or machine user) or an intermediate client hardware device gateway (e.g., a radio access network (RAN)) that may facilitate communication between a server and an endpoint client hardware device. Similarly, the non-transitory computer readable storage medium may include one or more mediums. Further, although the example program is described with reference to the flowchart illustrated in FIG. 2, many other methods of implementing the example memory controller 102 may alternatively be used. For example, the order of execution of the blocks of the flowchart(s) may be changed, and/or some of the blocks described may be changed, eliminated, or combined. Additionally or alternatively, any or all of the blocks of the flow chart may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The programmable circuitry may be distributed in different network locations and/or local to one or more hardware devices (e.g., a single-core processor (e.g., a single core CPU), a multi-core processor (e.g., a multi-core CPU, an XPU, etc.)). As used herein, programmable circuitry includes any type(s) of circuitry that may be programmed to perform a desired function such as, for example, a CPU, a GPU, a VPU, and/or an FPGA. The programmable circuitry may include one or more CPUs, one or more GPUs, one or more VPUs, and/or one or more FPGAs located in the same package (e.g., the same integrated circuit (IC) package or in two or more separate housings), one or more CPUs, GPUs, VPUs, and/or one or more FPGAs in a single machine, multiple CPUs, GPUs, VPUs, and/or FPGAs distributed across multiple servers of a server rack, and/or multiple CPUs, GPUs, VPUs, and/or FPGAs distributed across one or more server racks. Additionally or alternatively, programmable circuitry may include a programmable logic device (PLD), a generic array logic (GAL) device, a programmable array logic (PAL) device, a complex programmable logic device (CPLD), a simple programmable logic device (SPLD), a microcontroller (MCU), a programmable system on chip (PSoC), etc., and/or any combination(s) thereof in any of the contexts explained above.

The machine readable instructions described herein may be stored in one or more of a compressed format, an encrypted format, a fragmented format, a compiled format, an executable format, a packaged format, etc. Machine readable instructions as described herein may be stored as data (e.g., computer-readable data, machine-readable data, one or more bits (e.g., one or more computer-readable bits, one or more machine-readable bits, etc.), a bitstream (e.g., a computer-readable bitstream, a machine-readable bitstream, etc.), etc.) or a data structure (e.g., as portion(s) of instructions, code, representations of code, etc.) that may be utilized to create, manufacture, and/or produce machine executable instructions. For example, the machine readable instructions may be fragmented and stored on one or more storage devices, disks and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of computer-executable and/or machine executable instructions that implement one or more functions and/or operations that may together form a program such as that described herein.

In another example, the machine readable instructions may be stored in a state in which they may be read by programmable circuitry, but require addition of a library (e.g., a dynamic link library (DLL)), a software development kit (SDK), an application programming interface (API), etc., in order to execute the machine-readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable, computer readable and/or machine readable media, as used herein, may include instructions and/or program(s) regardless of the particular format or state of the machine readable instructions and/or program(s).

The machine readable instructions described herein can be represented by any past, present, or future instruction language, scripting language, programming language, etc. For example, the machine readable instructions may be represented using any of the following languages: C, C++, Java, C-Sharp, Perl, Python, JavaScript, HyperText Markup Language (HTML), Structured Query Language (SQL), Swift, etc.

As mentioned above, the example operations of FIG. 1 may be implemented using executable instructions (e.g., computer readable and/or machine readable instructions) stored on one or more non-transitory computer readable and/or machine readable media. As used herein, the terms non-transitory computer readable medium, non-transitory computer readable storage medium, non-transitory machine readable medium, and/or non-transitory machine readable storage medium are expressly defined to include any type of computer readable storage device and/or storage disk and to exclude propagating signals and to exclude transmission media. Examples of such non-transitory computer readable medium, non-transitory computer readable storage medium, non-transitory machine readable medium, and/or non-transitory machine readable storage medium include optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms "non-transitory computer readable storage device" and "non-transitory machine readable storage device" are defined to include any physical (mechanical, magnetic and/or electrical) hardware to retain information for a time period, but to exclude propagating signals and to exclude transmission media. Examples of non-transitory computer readable storage devices and/ or non-transitory machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer-readable instructions, machine-readable instructions, etc.

From the foregoing, it will be appreciated that example systems, apparatus, articles of manufacture, and methods have been disclosed that reduce the pin count of a computing platform to improve simplicity of memory and computing architecture as well as improve the bandwidth per pin efficiency. Disclosed systems, apparatus, articles of manufacture, and methods reduce the overall pin count of the computing platform by limiting a number of chip select pins to a maximum of two per channel, rather than one per rank, where the rank number can be up to 16. Disclosed systems, apparatus, articles of manufacture, and methods are accordingly directed to one or more improvement(s) on a machine such as a computer or other electronic device.

Example methods, apparatus, and systems for dynamic chip select modes are disclosed herein. Further examples and combinations thereof include the following:
Example 1 includes a system comprising a memory module including a first rank of dynamic random access devices (DRAMs), a second rank of DRAMs, and a third rank of DRAMs, a first signal line coupled to the memory module, a second signal line coupled to the memory module, and a host memory controller coupled to the first and second signal lines, the host memory controller to generate a multi-bit signal that selects the third rank of DRAM devices, and transmit bits of the multi-bit signal over the second signal line over multiple clock cycles.
Example 2 includes the system of example 1, wherein the first signal line and second signal line are chip select signal lines.
Example 3 includes the system of example 1, wherein the memory module further includes a buffering device to decode the multi-bit signal, and enable the third rank of DRAMs based on the decoded multi-bit signal.
Example 4 includes the system of example 1, further including a host computing platform including the host memory controller, an input/output (I/O) device to couple the host memory controller to the memory module, a first pin coupled to the I/O device and to the first signal line, and a second pin coupled to the I/O device and to the second signal line.
Example 5 includes the system of example 4, wherein the first and second pins supports up to eight ranks of DRAMs.
Example 6 includes the system of example 1, wherein the host memory controller is to determine whether the memory module has more than two ranks of DRAMs, and generate chip select commands in an encoded mode or a toggle mode based on the determination.
Example 7 includes the system of example 6, wherein the host memory controller is to determine that the memory module includes a buffering device, and configure the buffering device in the encoded mode or the toggle mode based on whether there is more than two ranks of DRAMs.
Example 8 includes the system of example 6, wherein the host memory controller is to generate chip select commands in encoded mode when there are more than two ranks of DRAMs, the encoded mode corresponding to the multi-bit signal sent over multiple clock cycles.
Example 9 includes the system of example 6, wherein the host memory controller is to generate chip select commands in toggle mode when there is two or less ranks of DRAMs, the toggle mode to toggle binary values on the first signal line and the second signal line to generate the chip select for the first or second rank of DRAMs.
Example 10 includes a memory device comprising memory packages to store data, and hardware logic to receive an instruction to enter into a first chip select mode or a second chip select mode, capture at least two bit values from a signal line, and determine, using the first chip select mode or the second chip select mode, which rank of memory packages to enable based on the at least two bit values.
Example 11 includes the memory device of example 10, wherein the first chip select mode is an encoded mode, the encoded mode to cause the hardware logic to decode bits from the signal line to determine which rank of memory packages to enable.
Example 12 includes the memory device of example 11, wherein the hardware logic is to capture a multi-bit signal sent over two or more clock cycles when operating in the first chip select mode.
Example 13 includes the memory device of example 10, wherein the second chip select mode is a toggle mode, the toggle mode to cause the hardware logic to buffer the at least two bit values directly to the memory packages to enable the rank of memory packages.
Example 14 includes the memory device of example 10, further including a buffering device to implement the hardware logic.
Example 15 includes the memory device of example 10, wherein the signal line is a chip select signal line.
Example 16 includes a non-transitory machine readable storage medium comprising instructions to cause programmable circuitry to at least determine a number of ranks of memory packages in a memory module, generate a multi-bit command signal based on the number of ranks of memory packages that selects a rank of DRAM packages, and transmit bits of the multi-bit command signal over a signal line over multiple clock cycles.
Example 17 includes the non-transitory machine readable storage medium of example 16, wherein the instructions are to cause programmable circuitry to at least generate the multi-bit command signal in an encoded mode when the number of ranks of memory packages is greater than two.
Example 18 includes the non-transitory machine readable storage medium of example 17, wherein the instructions are to cause programmable circuitry to at least determine that the memory module includes a buffering device, and configure the buffering device in the encoded mode to facilitate decoding the multi-bit command signal and identifying a rank of memory packages to enable.
Example 19 includes the non-transitory machine readable storage medium of example 16, wherein the instructions are to cause programmable circuitry to at least generate the multi-bit command signal in a toggle mode when the number of ranks of memory packages is equal to or less than two.
Example 20 includes the non-transitory machine readable storage medium of example 19, wherein the instructions are to cause programmable circuitry to at least determine that the memory module includes a buffering device, and configure the buffering device in the toggle mode to facilitate buffering the multi-bit command signal to a corresponding rank of memory packages to enable.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A system comprising:
a memory module including a first rank of dynamic random access devices (DRAMs), a second rank of DRAMs, and a third rank of DRAMs;
a first signal line coupled to the memory module;
a second signal line coupled to the memory module; and
a host memory controller coupled to the first and second signal lines, the host memory controller to:
generate a multi-bit signal that selects the third rank of DRAM devices; and
transmit bits of the multi-bit signal over the second signal line over multiple clock cycles.

2. The system of claim 1, wherein the first signal line and second signal line are chip select signal lines.

3. The system of any one of claims 1-2, wherein the memory module further includes a buffering device to:
decode the multi-bit signal; and
enable the third rank of DRAMs based on the decoded multi-bit signal.

4. The system of any one of claims 1-3, further including a host computing platform including:
the host memory controller;
an input/output (I/O) device to couple the host memory controller to the memory module;
a first pin coupled to the I/O device and to the first signal line; and
a second pin coupled to the I/O device and to the second signal line.

5. The system of claim 4, wherein the first and second pins support up to eight ranks of DRAMs.

6. The system of any one of claims 1-5, wherein the host memory controller is to:
determine whether the memory module has more than two ranks of DRAMs; and
generate chip select commands in an encoded mode or a toggle mode based on the determination.

7. The system of claim 6, wherein the host memory controller is to:
determine that the memory module includes a buffering device; and
configure the buffering device in the encoded mode or the toggle mode based on whether there is more than two ranks of DRAMs.

8. The system of claim 6, wherein the host memory controller is to generate chip select commands in encoded mode when there are more than two ranks of DRAMs, the encoded mode corresponding to the multi-bit signal sent over multiple clock cycles.

9. The system of claim 6, wherein the host memory controller is to generate chip select commands in toggle mode when there is two or less ranks of DRAMs, the toggle mode to toggle binary values on the first signal line and the second signal line to generate the chip select commands for the first or second rank of DRAMs.

10. A machine readable storage medium comprising instructions to cause programmable circuitry to at least:
determine a number of ranks of memory packages in a memory module;
generate a multi-bit command signal based on the number of ranks of memory packages that selects a rank of DRAM packages; and
transmit bits of the multi-bit command signal over a signal line over multiple clock cycles.

11. The machine readable storage medium of claim 10, wherein the instructions are to cause programmable circuitry to at least generate the multi-bit command signal in an encoded mode when the number of ranks of memory packages is greater than two.

12. The machine readable storage medium of claim 11, wherein the instructions are to cause programmable circuitry to at least:
determine that the memory module includes a buffering device; and
configure the buffering device in the encoded mode to facilitate decoding the multi-bit command signal and identifying a rank of memory packages to enable.

13. The machine readable storage medium of any one of claims 10-12, wherein the instructions are to cause programmable circuitry to at least generate the multi-bit command signal in a toggle mode when the number of ranks of memory packages is equal to or less than two.

14. The machine readable storage medium of claim 13, wherein the instructions are to cause programmable circuitry to at least:
determine that the memory module includes a buffering device; and
configure the buffering device in the toggle mode to facilitate buffering the multi-bit command signal to a corresponding rank of memory packages to enable.

15. A method comprising:
determining a number of ranks of memory packages in a memory module;
generating a multi-bit command signal based on the number of ranks of memory packages that selects a rank of DRAM packages; and
transmitting bits of the multi-bit command signal over a signal line over multiple clock cycles.
